# EUROPÄISCHE PATENTSCHRIFT

(11) **EP 3 245 034 B1**
(45) Veröffentlichungstag und Bekanntmachung des Hinweises auf die Patenterteilung: **25.03.2020**
(21) Anmeldenummer: 16700575.0
(22) Anmeldetag: 13.01.2016
(51) Int. Cl.: B28D 5/00, H01L 21/84, H01L 21/304

(54) **ABTRENNVORRICHTUNG ZUM SPANFREIEN ABTRENNEN VON WAFERN VON SPENDERSUBSTRATEN**
SEPARATING DEVICE FOR THE CHIP-FREE CUTTING OF WAFERS OF DONOR SUBSTRATES
DISPOSITIF DE SÉPARATION POUR SÉPARER SANS CONTRAINTES DES GALETTES DE SUBSTRATS DONNEURS

(30) Priorität: 15.01.2015 DE 102015000450
(43) Veröffentlichungstag der Anmeldung: 22.11.2017
(73) Patentinhaber: Siltectra GmbH, 01099 Dresden (DE)
(72) Erfinder: RICHTER, Jan, 01109 Dresden (DE)
(74) Vertreter: Westphal, Mussgnug & Partner Patentanwälte mbB
(86) Internationale Anmeldenummer: PCT/EP2016/050576
(87) Internationale Veröffentlichungsnummer: WO 2016/113311

(56) Entgegenhaltungen:
- WO-A1-2014/177721
- US-A1- 2009 032 505
- DATABASE COMPENDEX [Online] ENGINEERING INFORMATION, INC., NEW YORK, NY, US; Oktober 2007 (2007-10), DROSS F ET AL: "Stress-induced large-area lift-off of crystalline Si films", XP002755956, Database accession no. E20074710925111 & APPLIED PHYSICS A: MATERIALS SCIENCE AND PROCESSING - SPECIAL ISSUE ON TRANSPARENT CONDUCTING OXIDES (TCO) OCTOBER 2007 SPRINGER VERLAG DE, Bd. 89, Nr. 1, Oktober 2007 (2007-10), Seiten 149-152, DOI: 10.1007/S00339-007-4195-2

## Beschreibung

Die vorliegende Erfindung bezieht sich gemäß Anspruch 1 auf eine Vorrichtung zum spanfreien Abtrennen von mindestens einem Wafer von einem Spendersubstrat. Eine solche Vorrichtung, gemäß dem Oberbegriff des Anspruchs 1, ist in WO2014/177721 offenbart.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in WO2009/061353 und WO2010/072675 beschrieben sind, wo zum Erzeugen dieser Spannungen eine auf das Werkstück aufgetragene Polymerschicht verwendet wird. Die Gegenstände der zuvor genannten Schutzrechtsschriften werden durch Bezugnahme vollständig zum Gegenstand der vorliegenden Schutzrechtsschrift gemacht.

Die Polymerschicht weist bei den erwähnten Verfahren einen im Vergleich zum Werkstück um ungefähr zwei Größenordnungen höheren thermischen Expansionskoeffizienten auf. Außerdem kann durch Ausnutzen eines Glasübergangs ein relativ hohes Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Es ist die Aufgabe der vorliegenden Erfindung eine Vorrichtung zum spanfreien Abtrennen von mindestens einem Festkörperanteil von einem Spendersubstrat bereitzustellen.

Die zuvor genannte Aufgabe wird gemäß Anspruch 1 durch eine Vorrichtung zum spanfreien Abtrennen von mindestens einem Wafer von einem Spendersubstrat bzw. durch eine Abtrennvorrichtung gelöst. Die erfindungsgemäße Vorrichtung umfasst dabei mindestens ein Gehäuse mit einem Aufnahmeraum zum Aufnehmen von mindestens einer Mehrschichtanordnung zumindest bestehend aus einem Spendersubstrat und einer daran angeordneten oder erzeugen Aufnahmeschicht, und eine Beaufschlagungseinrichtung zum kontaktlosen Beaufschlagen der Mehrschichtanordnung zum Erzeugen von Rissführungsspannungen in der Mehrschichtanordnung. Die Aufnahmeschicht besteht bevorzugt aus einem Polymer, insbesondere aus Polydimethylsiloxane (PDMS).

Diese Lösung ist vorteilhaft, da erstmals eine Vorrichtung für ein spanfreies Abtrennverfahren zum spanfreien Abtrennen von Wafern von einem Spendersubstrat, insbesondere von einem dicken Wafer oder einem Ingot, bereitgestellt wird, wobei die Vorrichtung günstig herstellbar und wiederholt einsetzbar ist sowie wenig Bauraum bedingt.

Weitere vorteilhafte Ausführungsformen sind Gegenstand der nachfolgenden Beschreibung und/oder der Unteransprüche.

Die Rissauslösespannungen können gemäß einer bevorzugten Ausführungsform der vorliegenden Erfindung kontaktlos durch die Beaufschlagungseinrichtung erzeugt werden. Diese Ausführungsform ist vorteilhaft, da die Rissauslösung und die Rissführung durch dieselbe Einrichtung beeinflusst bzw. bewirkt werden und daher keine weitere Einrichtung erforderlich ist, wodurch eine sehr kleine, platz- und energiesparende Bauform möglich ist.

Gemäß einer weiteren bevorzugten Ausführungsform ist eine Rissinitiierungseinrichtung zum Auslösen des Risses vorgesehen, wobei eine Rissauslösung mittels der Rissinitiierungseinrichtung kontaktlos oder durch Kontakt mit der Mehrschichtanordnung, insbesondere dem Festkörper, bewirkbar ist. Diese Ausführungsform ist vorteilhaft, da durch die Rissinitiierungseinrichtung gezielt eine Rissauslösung bewirkt werden kann. Ferner kann die Rissinitiierungseinrichtung die Rissauslösung mittels eines Effekts bewirken, der von dem durch die Beaufschlagungseinrichtung zur Rissführung erzeugten Effekt verschieden ist. Bevorzugt ist die Rissinitiierungseinrichtung eine Sprühdüse, insbesondere zum gezielten Zuführen der fluidischen Substanz zu der Mehrschichtanordnung, insbesondere dem Spendersubstrat, oder eine Schallerzeugungseinrichtung oder eine Strahlungseinrichtung, insbesondere ein Laser, oder eine Druckerzeugungseinrichtung, die z.B. durch physischen Kontakt mit der Mehrschichtanordnung, insbesondere mit dem Festkörper, lokal die Rissauslösung bewirkt.

Die Beaufschlagungseinrichtung ist gemäß einer weiteren bevorzugten Ausführungsform zum Einbringen einer fluidischen Substanz in den Aufnahmeraum ausgebildet. Bevorzugt ist mittels der fluidischen Substanz zumindest abschnittsweise die Mehrschichtanordnung, insbesondere die Aufnahmeschicht, derart temperierbar, dass die Rissauslösespannungen und/oder die Rissführungsspannungen durch die Aufnahmeschicht in dem Festkörper erzeugt werden. Bevorzugt weist die Aufnahmeschicht einen thermischen Ausdehnungskoeffizienten auf, der von dem thermischen Ausdehnungskoeffizienten des Spendersubstrats um mindestens eine Größenordnung verschieden ist, wobei durch die thermische Beaufschlagung der Aufnahmeschicht derart Spannungen in dem Festkörper erzeugt werden, dass sich durch die Spannungen ein Riss in dem Festkörper entlang einem Ablösebereich ausbreitet, durch den der Festkörperanteil von dem Festkörper getrennt wird. Diese Ausführungsform ist vorteilhaft, da die fluidische Substanz außerhalb des Gehäuses, insbesondere in einer Bevorratungseinrichtung, insbesondere einem Tank, vorhaltbar und/oder aufbereitbar ist. Bevorzugt können an die Bevorratungseinrichtung mehrere erfindungsgemäße Vorrichtungen angekoppelt werden, wobei alle angekoppelten Vorrichtung bevorzugt aus der Bevorratungseinrichtung mit der fluidischen Substanz versorgt werden. Besonders bevorzugt weist die erfindungsgemäße Vorrichtung über eine Leitungsverbindung eine Kopplung mit der Bevorratungseinrichtung auf.

Die Beaufschlagungseinrichtung weist erfindungsgemäß mehrere Zuführmittel zum Zuführen der fluidischen Substanz in den Aufnahmeraum, insbesondere zu der in dem Aufnahmeraum angeordnet Mehrschichtanordnung, auf. Erfindungsgemäß ist zumindest eines der Zuführmittel derart gestaltet oder betreibbar, dass mittels dieses Zuführmittels eine Rissauslösung bewirkbar ist, wobei durch mindestens eines der Zuführmittel die fluidische Substanz nebelartig in den Aufnahmeraum sprühbar ist. Erfindungsgemäß weist die Aufnahmeschicht einen thermischen Ausdehnungskoeffizienten auf, der von dem thermischen Ausdehnungskoeffizienten des Spendersubstrats um mindestens eine Größenordnung verschieden ist, wobei durch die thermische Beaufschlagung der Aufnahmeschicht derart Spannungen in dem Festkörper erzeugt werden, dass durch die Spannungen ein Riss in dem Festkörper ausgelöst wird, durch den der Festkörperanteil von dem Festkörper getrennt wird.

Die Zuführmittel weisen bevorzugt Vernebelungselemente auf. Weiterhin ist bevorzugt eine Pumpeinrichtung zum Fördern der fluidischen Substanz aus der Bevorratungseinrichtung zum Zuführmittel bzw. zu den Zuführmitteln vorgesehen.

Die fluidische Substanz ist ein Fluid und bevorzugt eine Flüssigkeit, insbesondere flüssiger Stickstoff (N₂). Besonders bevorzugt weist die fluidische Substanz eine nebelförmige oder nebelartige Gestalt auf. Dies ist vorteilhaft, da die fluidische Substanz derart ausgewählt werden kann, dass mittels ihr eine definierte Temperierung der Mehrschichtanordnung bewirkbar ist. Die Verwendung von flüssigem Stickstoff als fluidische Substanz ermöglicht ein schnelles Abkühlen, da flüssiger Stickstoff kälter als -196°C ist, bevorzugt wird jedoch nebelartiger oder nebelförmiger Stickstoff, der bevorzugt eine Temperatur von mehr als -196°C aufweist, verwendet.

Der Aufnahmeraum ist gemäß einer weiteren bevorzugten Ausführungsform der vorliegenden Erfindung evakuierbar, wobei bevorzugt eine Vakuumpumpe vorgesehen ist, die mit dem Aufnahmeraum eine Wirkverbindung ausbildet. Diese Ausführungsform ist vorteilhaft, da durch die Evakuierung der Aufnahmeraum effektiv und einfach von ungewünschten Stoffen, insbesondere von Wasser, befreit werden kann. Durch diese Ausführungsform kann zum Beispiel eine Wasserbenetzung der Mehrfachanordnung und/oder des Innenraums und/oder des abgetrennten Festkörperanteils verhindert bzw. reduziert werden.

Eine Halte- und/oder Homogenisierungseinrichtung zum Halten und/oder Homogenisieren der in den Aufnahmeraum eingebrachten fluidischen Substanz ist gemäß einer weiteren bevorzugten Ausführungsform der vorliegenden Erfindung im Aufnahmeraum angeordnet, wobei die Halte- und/oder Homogenisierungseinrichtung bevorzugt rohrförmig, insbesondere ringförmig, ausgebildet ist. Diese Ausführungsform ist vorteilhaft, da durch die Halte- und/oder Homogenisierungseinrichtung die in den Aufnahmeraum eingebrachte fluidischen Substanz in eine Konfiguration überführbar ist, in der sie vorteilhaft, insbesondere gleichförmig, auf die Mehrschichtanordnung einwirkt bzw. die Mehrschichtanordnung temperiert.

Eine Heizung zum Temperieren des Spendersubstrats und/oder des Aufnahmeraums ist gemäß einer weiteren bevorzugten Ausführungsform der vorliegenden Erfindung in dem Aufnahmeraum oder am Gehäuse angeordnet, wobei durch die Heizung bevorzugt eine Aufheizung des Spendersubstrats und/oder des Aufnahmeraums von einer Temperatur unter 0°C, insbesondere von unter -50°C oder von unter -100°C oder von unter -150°C, auf Raumtemperatur bewirkbar ist. Diese Ausführungsform ist vorteilhaft, da z.B. das Kondensieren von Flüssigkeit an dem Festkörper und/oder im Aufnahmeraum verhindert wird. Weiterhin können durch diese Ausführungsform thermische Schocks, die infolge eines zu schnellen Aufwärmens des Spendersubstrats (z.B. infolge des Öffnens des Gehäuses) auftreten können, verhindert werden.

Gemäß einer weiteren bevorzugten Ausführungsform der vorliegenden Erfindung ist eine gefederte oder gedämpfte Aufnahmeeinrichtung zum gefederten oder gedämpften Aufnehmen des abgetrennten Wafers in dem Aufnahmeraum angeordnet, wobei die gefederte oder gedämpfte Aufnahmeeinrichtung bevorzugt an der Halte- und/oder Homogenisierungseinrichtung angeordnet ist. Diese Ausführungsform ist vorteilhaft, da durch die beim Abtrennen in den Festkörper bzw. das Spendersubstrat eingeleiteten Kräfte der abgetrennte Wafer bzw. Festkörperanteil dazu neigt wegzuspringen, insbesondere in Längsrichtung des Spendersubstrates. Der Wafer bzw. Festkörperanteil kann durch diese Ausführungsform kontrolliert gehalten oder aufgenommen werden, wodurch eine Beschädigung des Wafers bzw. Festkörperanteils und/oder des Aufnahmeraums und/oder von Einrichtungen in dem Aufnahmeraum, verhindert wird.

Der Festkörper bzw. das Werkstück bzw. das Spendersubstrat weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können.

Die Verwendung der Wörter "im Wesentlichen" definiert bevorzugt in allen Fällen, in denen diese Wörter im Rahmen der vorliegenden Erfindung verwendet werden eine Abweichung im Bereich von 1%-30%, insbesondere von 1%-20%, insbesondere von 1%-10%, insbesondere von 1%-5%, insbesondere von 1%-2%, von der Festlegung, die ohne die Verwendung dieser Wörter gegeben wäre.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Vorrichtung dargestellt ist. Bauteile oder Elemente der erfindungsgemäßen Vorrichtung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigen:
- Fig. 1: eine schematische Darstellungen der im Aufnahmeraum der erfindungsgemäßen Vorrichtung miteinander zusammenwirkenden Einrichtungen; und
- Fig. 2: eine schematische Außenansicht der erfindungsgemäßen Abtrennvorrichtung.

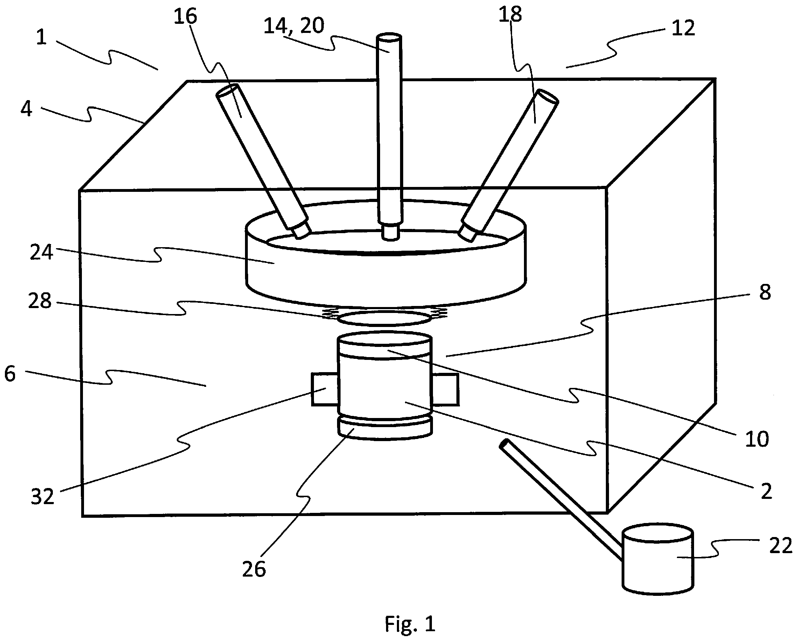

Fig. 1 zeigt die erfindungsgemäße Vorrichtung 1 zum Abtrennen von mindestens einem Festkörperanteil, insbesondere einem Wafer, wie z.B. einem 8 inch Wafer, von einem Spendersubstrat 2. Es kann der Darstellung entnommen werden, dass die erfindungsgemäße Abtrennvorrichtung bevorzugt zumindest ein Gehäuse 4 mit einem Aufnahmeraum 6 zum Aufnehmen von mindestens einer Mehrschichtanordnung 8 aufweist, wobei die Mehrschichtanordnung 8 bevorzugt ein Spendersubstrat 2 und eine daran angeordneten oder erzeugen Aufnahmeschicht 10 aufweist, und eine Beaufschlagungseinrichtung 12 zum kontaktlosen Beaufschlagen der Mehrschichtanordnung 8 zum Erzeugen von zumindest Rissführungsspannungen in der Mehrschichtanordnung 8 aufweist.

Das Bezugszeichen 14 kennzeichnet bevorzugt eine Rissinitiierungseinrichtung zum Auslösen des Risses, wobei eine Rissauslösung mittels der Rissinitiierungseinrichtung 14 bevorzugt kontaktlos oder durch Kontakt mit der Mehrschichtanordnung 8, insbesondere dem Spendersubstrat 2, bewirkbar ist. Im gezeigten Fall ist die Rissinitiierungseinrichtung bevorzugt als spezielles Zuführmittel 20 zum Zuführen der fluidischen Substanz, insbesondere flüssigem Stickstoff, ausgebildet.

Die Beaufschlagungseinrichtung 12, die bevorzugt die Zuführmittel 16, 18, 20 umfasst, dient bevorzugt zum Einbringen der fluidischen Substanz in den Aufnahmeraum 6. Mittels der fluidischen Substanz ist zumindest abschnittsweise die Mehrschichtanordnung 8, insbesondere die Aufnahmeschicht 10, derart temperierbar, insbesondere abkühlbar, dass die Rissauslösespannungen und/oder die Rissführungsspannungen durch eine Komprimierung der Aufnahmeschicht 10 in dem Spendersubstrat 2 erzeugt werden. Bevorzugt sind die Zuführmittels 16, 18, 20 oder eines der Zuführmittel oder mindestens eines der Zuführmittel als Sprühdüse ausgebildet bzw. weist die Sprühdüse auf. Das verbleibende oder die verbleibenden Zuführmittel sind dann bevorzugt zum Vernebeln der fluidischen Substanz, insbesondere des flüssigen Stickstoffs, ausgebildet.

Das Gehäuse 4 ist bevorzugt derart verschließbar, dass der Aufnahmeraum 6 evakuiert werden kann. Bevorzugt ist eine Pumpeinrichtung, insbesondere eine Vakuumpumpe 22, vorgesehen, die mit dem Aufnahmeraum 6 derart eine Wirkverbindung ausbildet, dass frei beweglichen Substanzen, insbesondere Verunreinigungen, wie Gase oder Flüssigkeiten oder Staub, über die Wirkverbindung aus dem Aufnahmeraum 6 herausförderbar sind.

Das Bezugszeichen 24 kennzeichnet eine Halte- und/oder Homogenisierungseinrichtung zum Halten und/oder Homogenisieren der in den Aufnahmeraum 6 eingebrachten fluidischen Substanz und ist bevorzugt im Aufnahmeraum 6 angeordnet. Die Halte- und/oder Homogenisierungseinrichtung 24 ist bevorzugt rohrförmig, insbesondere ringförmig, oder als Ring ausgebildet.

Weiterhin ist bevorzugt eine Heizeinrichtung 26 zum Temperieren des Spendersubstrats 2 in dem Aufnahmeraum 6 oder am Gehäuse 4 angeordnet.

Durch das Bezugszeichen 28 wird eine gefederte oder gedämpfte Aufnahmeeinrichtung gekennzeichnet, die bevorzugt zum gefederten oder gedämpften Aufnehmen des abgetrennten Festkörperanteils in dem Aufnahmeraum 6, bevorzugt in Längsrichtung des Spendersubstrates oberhalb des Spendersubstrat, angeordnet ist.

Die Mehrschichtanordnung 8 wird bevorzugt mittels einer Positionier- und/oder Fixiereinrichtung 32 ausgerichtet und/oder fixiert. Bevorzugt wirkt die Positionier- und/oder Fixiereinrichtung kraft- und/oder formschlüssig mit der Mehrschichtanordnung 8 zusammen.

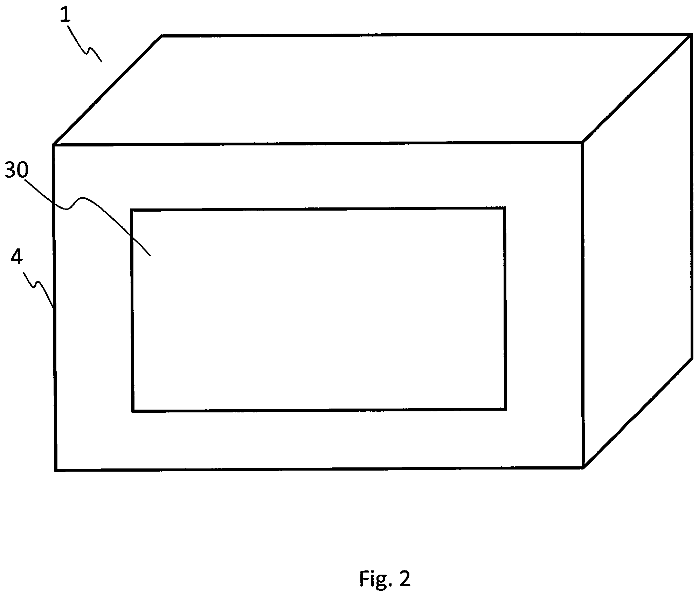

Fig. 2 zeigt das Gehäuse 4 der Abtrennvorrichtung 1 in einer weiteren schematischen Ansicht. Es ist dieser Ansicht eine öffnungs- und Verschlusseinrichtung 30 zu entnehmen, die zum Einbringen der Mehrschichtanordnung 8 in den Aufnahmeraum 6 oder zum Herausnehmen des abgetrennten Festkörperanteils und des reduzierten Spendersubstrats 2 aus dem Aufnahmeraum 6 ausgebildet ist. Die Öffnungs- und Verschlusseinrichtung 30 ist bevorzugt derart verschließbar, dass im Inneren des Gehäuses 4, insbesondere im Aufnahmeraum 6, ein gegenüber dem Umgebungsdruck reduzierter Unterdruck oder ein Vakuum bzw. im Wesentlichen ein Vakuum erzeugbar ist.

Besonders bevorzugt erstreckt sich das Gehäuse 4 der erfindungsgemäßen Vorrichtung 1 in Breitenrichtung weniger als 100cm, insbesondere weniger als 60cm oder weniger als 50cm. Bevorzugt erstreckt sich das Gehäuse 4 in Breitenrichtung bevorzugt bis zu 30cm oder genau 30cm oder bis zu 35cm oder bis zu 40 cm. Besonders bevorzugt erstreckt sich das Gehäuse 4 der erfindungsgemäßen Vorrichtung 1 in Längenrichtung weniger als 100cm, insbesondere weniger als 60cm oder weniger als 50cm. Bevorzugt erstreckt sich das Gehäuse 4 in Längenrichtung bevorzugt bis zu 30cm oder genau 30cm oder bis zu 35cm oder bis zu 40 cm. Besonders bevorzugt erstreckt sich das Gehäuse 4 der erfindungsgemäßen Vorrichtung 1 in Höhenrichtung weniger als 100cm, insbesondere weniger als 60cm oder weniger als 50cm. Bevorzugt erstreckt sich das Gehäuse 4 in Höhenrichtung bevorzugt bis zu 30cm oder genau 30cm oder bis zu 35cm oder bis zu 40 cm. Aufgrund der geringen Abmessungen des Gehäuses ist eine Parallelisierung der Abtrennung von Festkörperanteilen problemlos durch eine größere Anzahl an erfindungsgemäßen Vorrichtungen auch auf kleinem Raum möglich.

Beim Abtrennen des Festkörperanteils werden bevorzugt die nachfolgenden Schritte durchgeführt: Bevorzugt wird in einem ersten Schritt die Mehrschichtanordnung 8 in den Aufnahmeraum 6 eingebracht. Anschließend wird bevorzugt ein Vakuum gezogen. In einem weiteren Schritt wird bevorzugt von oben das fluidische Material, insbesondere flüssiger Stickstoff, in den Aufnahmeraum 6 eingebracht, insbesondere eingesprüht. Hierdurch ist eine sehr zielgenau Temperierung, insbesondere Kühlung, der Aufnahmeschicht 6 und/oder des Spendersubstrats 2 möglich. Bevorzugt wird die Aufnahmeschicht 6 durch das fluidische Material auf eine Temperatur unterhalb der Glasübergangstemperatur des Materials der Aufnahmeschicht 6 abgekühlt. Besonders bevorzugt erfolgt über ein bevorzugt als Splitdüse ausgebildetes Zuführmittel 20 eine definierte Abkühlung eines kleinen Teils der Mehrschichtanordnung 8, insbesondere des Spendersubstrates 2 und/oder der Aufnahmeschicht 6. Als kleiner Teil ist hierbei bevorzugt eine Fläche zu verstehen die kleiner als ein Drittel oder kleiner als ein Sechstel oder kleiner als ein Zehntel oder kleiner als ein Zwanzigstel oder kleiner als ein Dreißigstel der Oberfläche der Aufnahmeschicht 6 ist. In einem weiteren Schritt wird bevorzugt eine Bewegung des abgetrennte Festkörperanteil bzw. der Wafer durch eine Aufnahmeeinrichtung 28 oder Federungs- und/oder Dämpfungseinrichtung 28 abgefedert oder gedämpft, wodurch der abgetrennte, insbesondere abgesplittete, Festkörperanteil auf dem Spendersubstrat 2 bzw. Werkstück zum Liegen kommt. Nach dem Abtrennen des Festkörperanteils wird das Spendersubstrat bevorzugt mittels einer Heizeinrichtung 26, insbesondere einer elektrischen Widerstandsheizung, auf eine Temperatur oberhalb 0°C, bevorzugt oberhalb 10°C und besonders bevorzugt auf Raumtemperatur, aufgeheizt. In einem letzten Schritt wird das Gehäuse 4 geöffnet und der abgetrennte Festkörperanteil aus dem Aufnahmeraum 6 entfernt. Weiterhin ist denkbar, dass auch das Spendersubstrat 2 ausgetauscht oder neu mit einer Aufnahmeschicht beschichtet wird.

### Bezugszeichenliste

- 1: Vorrichtung
- 2: Spendersubstrat
- 4: Gehäuse
- 6: Aufnahmeraum
- 8: Mehrschichtanordnung
- 10: Aufnahmeschicht
- 12: Beaufschlagungseinrichtung
- 14: Rissinitiiereinrichtung
- 16: Erstes Zuführmittel
- 18: Zweites Zuführmittel
- 20: Drittes Zuführmittel
- 22: Pumpeinrichtung
- 24: Halte- und/oder Homogenisierungseinrichtung
- 26: Heizeinrichtung
- 28: Aufnahmeeinrichtung
- 30: Öffnungs- und Verschlusseinrichtung
- 32: Positionier- und/oder Fixiereinrichtung

## Patentansprüche

1. Vorrichtung (1) zum Abtrennen von mindestens einem Festkörperanteil, insbesondere einem Wafer, von einem Spendersubstrat (2), insbesondere einem Ingot,
mindestens umfassend
ein Gehäuse (4) mit einem Aufnahmeraum (6) zum Aufnehmen von mindestens einer Mehrschichtanordnung (8) zumindest bestehend aus einem Spendersubstrat (2) und einer daran angeordneten oder erzeugten Aufnahmeschicht (10), und
eine Beaufschlagungseinrichtung (12) zum kontaktlosen Beaufschlagen der Mehrschichtanordnung (8) zum Erzeugen von Rissführungsspannungen in der Mehrschichtanordnung (8), **dadurch gekennzeichnet dass**
die Beaufschlagungseinrichtung (12) mehrere Zuführmittel (16, 18, 20) zum Zuführen der fluidischen Substanz, insbesondere flüssigem Stickstoff, aufweist, wobei durch mindestens eines der Zuführmittel (16, 18, 20) die fluidische Substanz nebelartig in den Aufnahmeraum (6) sprühbar ist, wobei bevorzugt zumindest eines der Zuführmittel (20) derart gestaltet oder betreibbar ist, dass mittels dieses Zuführmittels (20) eine Rissauslosung bewirkbar ist,
wobei die Aufnahmeschicht einen thermischen Ausdehnungskoeffizienten aufweist, der von dem thermischen Ausdehnungskoeffizienten des Spendersubstrats (2) um mindestens eine Größenordnung verschieden ist,
wobei durch die thermische Beaufschlagung der Aufnahmeschicht (10) derart Spannungen in dem Festkörper (2) erzeugt werden, dass durch die Spannungen ein Riss in dem Festkörper (2) ausgelost wird, durch den der Festkörperanteil von dem Festkörper (2) getrennt wird.

2. Vorrichtung nach Anspruch 1,
**dadurch gekennzeichnet, dass**
Rissauslösespannungen ebenfalls kontaktlos durch die Beaufschlagungseinrichtung (12) erzeugt werden.

3. Vorrichtung nach Anspruch 1,
**dadurch gekennzeichnet, dass**
eine Rissinitiierungseinrichtung (14) zum Auslösen des Risses vorgesehen ist,
wobei eine Rissauslosung mittels der Rissinitiierungseinrichtung (14) kontaktlos oder durch Kontakt mit der Mehrschichtanordnung (8), insbesondere dem Spendersubstrat (2), bewirkbar ist.

4. Vorrichtung nach einem der vorangegangenen Anspruche,
**dadurch gekennzeichnet, dass**
die Beaufschlagungseinrichtung (12) zum Einbringen einer fluidischen Substanz in den Aufnahmeraum (6) ausgebildet ist, wobei mittels der fluidischen Substanz zumindest abschnittsweise die Mehrschichtanordnung (8), insbesondere die Aufnahmeschicht (10), derart temperierbar ist, dass die Rissauslösespannungen und/oder die Rissführungsspannungen durch die Aufnahmeschicht (10) in dem Spendersubstrat (2) erzeugt werden, wobei die Aufnahmeschicht einen thermischen Ausdehnungskoeffizienten aufweist, der von dem thermischen Ausdehnungskoeffizienten des Spendersubstrats (2) um mindestens eine Größenordnung verschieden ist,
wobei durch die thermische Beaufschlagung der Aufnahmeschicht (10) derart Spannungen in dem Festkörper (2) erzeugt werden, dass sich durch die Spannungen ein Riss in dem Festkörper (2) entlang einem Ablösebereich ausbreitet, durch den der Festkörperanteil von dem Festkörper (2) getrennt wird.

5. Vorrichtung nach einem der vorangegangenen Anspruche,
**dadurch gekennzeichnet, dass**
der Aufnahmeraum (6) evakuierbar ausgestaltet ist, wobei bevorzugt eine Pumpeinrichtung, insbesondere eine Vakuumpumpe (22), vorgesehen ist, die mit dem Aufnahmeraum (6) eine Wirkverbindung ausbildet.

6. Vorrichtung nach einem der vorangegangenen Anspruche,
**dadurch gekennzeichnet, dass**
eine Halte- und/oder Homogenisierungseinrichtung (24) zum Halten und/oder Homogenisieren der in den Aufnahmeraum (6) eingebrachten fluidischen Substanz im Aufnahmeraum (6) angeordnet ist, wobei die Halte- und/oder Homogenisierungseinrichtung (24) bevorzugt rohrformig, insbesondere ringformig, ausgebildet ist.

7. Vorrichtung nach einem der vorangegangenen Anspruche,
**dadurch gekennzeichnet, dass**
eine Heizeinrichtung (26) zum Temperieren des Spendersubstrats (2) in dem Aufnahmeraum (6) oder am Gehäuse (4) angeordnet ist, wobei durch die Heizeinrichtung (26) bevorzugt eine Aufheizung des Spendersubstrats (2) von einer Temperatur unter 0°C, insbesondere von unter -50°C oder von unter -100°C oder von unter -150°C, auf Raumtemperatur bewirkbar ist.

8. Vorrichtung nach einem der vorangegangenen Anspruche,
**dadurch gekennzeichnet, dass**
eine gefederte oder gedampfte Aufnahmeeinrichtung (28) zum gefederten oder gedampften Aufnehmen des abgetrennten Festkörperanteils in dem Aufnahmeraum (6) angeordnet ist, wobei die gefederte oder gedampfte Aufnahmeeinrichtung (28) bevorzugt an der Halte und/oder Homogenisierungseinrichtung (24) angeordnet ist.

## Claims

1. Device (1) for cutting of at least one solid body portion, in particular a wafer, from a donor substrate (2), in particular an ingot,
at least comprising
a housing (4) with a receiving space (6) for receiving at least one multi-layer arrangement (8), consisting of at least one donor substrate (2) and one receiving layer (10) arranged or generated thereon, and
an loading device (12) for the contactless loading of the multi-layer arrangement (8) for generating crack conducting stresses in the multi-layer arrangement (8), **characterized in that**
the loading device (12) comprises a plurality of feed means (16, 18, 20) for feeding the fluid substance, in particular liquid nitrogen, wherein the fluid substance can be sprayed into the receiving space (6) in the form of a mist through at least one of the feed means (16, 18, 20), wherein preferably at least one of the feed means (20) is configured or operable in such manner that a crack initiation can be caused by means of said feed means (20),
wherein the receiving layer has a coefficient of thermal expansion that differs from the coefficient of thermal expansion of the donor substrate (2) by at least one order of magnitude,
wherein stresses are created in the solid body (2) by the thermal loading of the receiving layer (10) in such manner that the stresses initiate a crack in the solid body (2), by which the solid body portion is separated from the solid body (2).

2. Device according to claim 1,
**characterized in that**
crack initiating stresses are also generated without contact by the loading device (12).

3. Device according to claim 1,
**characterized in that**
a crack initiating device (14) is provided to initiate the crack,
wherein a crack initiation can be effected by means of the crack initiating device (14) either without contact or by contact with the multi-layer arrangement (8), in particular the donor substrate (2).

4. Device according to one of the preceding claims,
**characterized in that**
the loading device (12) is designed to introduce a fluid substance into the receiving space (6), wherein the temperature of at least a part of the multi-layer arrangement (8), in particular the receiving layer (10), can be controlled by means of the fluid substance in such manner that the crack initiating stresses and/or the crack conducting stresses are generated in the donor substrate (2) via the receiving layer (10),
wherein the receiving layer has a coefficient of thermal expansion that differs from the coefficient of thermal expansion of the donor substrate (2) by at least an order of magnitude,
wherein stresses are created in the solid body (2) by the thermal loading of the receiving layer (10) in such manner that, under the stresses, a crack in the solid body (2) propagates along a separation area, by which the solid body portion is separated from the solid body (2).

5. Device according to one of the preceding claims,
**characterized in that**
the receiving space (6) is designed such that it can be evacuated, wherein preferably a pump device, in particular a vacuum pump (22) is provided, which forms an operative connection with the receiving space (6).

6. Device according to any one of the preceding claims,
**characterized in that**
a holding and/or homogenizing device (24) is arranged in the receiving space (6) for holding and/or homogenizing the fluid substance which is introduced into the receiving space (6), wherein the holding and/or homogenizing device (24) is preferably tubular, in particular annular in shape.

7. Device according to any one of the preceding claims,
**characterized in that**
a heating device (26) for controlling the temperature of the donor substrate (2) is arranged in the receiving space (6) or on the housing (4), wherein preferably a heating of the donor substrate (2) from a temperature below 0°C, in particular below -50°C or below -100°C or below -150°C, to room temperature can be effected by the heating device (26).

8. Device according to any one of the preceding claims,
**characterized in that**
a spring-mounted or damped receiving device (28) is arranged in the receiving space (6) for spring-loaded or damped receiving of the separated solid body portion, wherein the spring-mounted or damped receiving device (28) is preferably arranged on the holding and/or homogenizing device (24).

## Revendications

1. Dispositif (1) de séparation d'au moins une partie de corps solide, en particulier un wafer, d'un substrat donneur (2), en particulier un lingot,
comprenant au moins
un boîtier (4) avec un espace de réception (6) destiné à recevoir au moins un ensemble multicouche (8) composé d'au moins un substrat donneur (2) et une couche de réception (10) disposée ou fabriquée sur celui-ci, et
un dispositif de charge (12) destiné à charger sans contact l'ensemble multicouche (8) afin de produire des tensions de guidage de fissure dans l'ensemble multicouche (8), **caractérisé en ce que**
le dispositif de charge (12) comprend plusieurs moyens d'alimentation (16, 18, 20) destinés à faire passer la substance fluide, en particulier de l'azote liquide, selon lequel la substance fluide est pulvérisable sous forme de brume dans l'espace de réception (6) via au moins un des moyens d'alimentation (16, 18, 20), selon lequel de préférence au moins un des moyens d'alimentation (20) est conçu ou opérable de manière à ce qu'une amorce de fissure puisse être provoquée au moyen de ce moyen d'alimentation (20), selon lequel la couche de réception a un coefficient de dilatation thermique différent du coefficient de dilatation thermique du substrat donneur (2) d'au moins un ordre de grandeur,
selon lequel sous la sollicitation thermique de la couche de réception (10) des tensions sont créées dans le corps solide (2) de manière à ce que les tensions provoquent une fissure dans le corps solide (2) par laquelle la partie de corps solide est séparée du corps solide (2).

2. Dispositif selon la revendication 1,
**caractérisé en ce que**
des tensions provocatrices de fissure sont également créées sans contact par le dispositif de charge (12).

3. Dispositif selon la revendication 1,
**caractérisé en ce que**
un dispositif d'initiation de fissure (14) est prévu pour amorcer les fissures,
selon lequel une amorce de fissure peut être provoquée au moyen du dispositif d'initiation de fissure (14) sans contact ou par contact avec l'ensemble multicouche (8), en particulier le substrat donneur (2).

4. Dispositif selon l'une des revendications précédentes,
**caractérisé en ce que**
le dispositif de charge (12) est conçu de manière à apporter la substance fluide dans l'espace de réception (6), selon lequel la température d'au moins une partie de l'ensemble multicouche (8), en particulier la couche de réception (10), peut être réglée au moyen de la substance fluide, de telle manière que les tensions d'amorce de fissure et/ou les tensions de guidage de fissure sont provoquées dans le substrat donneur (2) par la couche de réception (10),
selon lequel la couche de réception a un coefficient de dilatation thermique différent du coefficient de dilatation thermique du substrat donneur (2) d'au moins un ordre de grandeur,
selon lequel des tensions dans le corps solide (2) sont créées sous la sollicitation thermique de la couche de réception (10) de façon à ce qu'une fissure dans le corps solide (2) se propage sous l'effet des tensions le long d'une zone de détachement par laquelle la partie de corps solide est séparée du corps solide (2).

5. Dispositif selon l'une des revendications précédentes,
**caractérisé en ce que**
l'espace de réception (6) est conçu pour être évacuable, selon lequel de préférence un dispositif de pompe, en particulier une pompe à vide (22), est prévu, lequel forme avec l'espace de réception (6) une liaison active.

6. Dispositif selon l'une des revendications précédentes,
**caractérisé en ce que**
un dispositif de maintien et/ou d'homogénéisation (24) destiné à retenir et/ou à homogénéiser la substance fluide apportée dans l'espace de réception (6) est disposé dans l'espace de réception (6), selon lequel le dispositif de maintien et/ou d'homogénéisation (24) est de préférence en forme de tube, en particulier en forme d'anneau.

7. Dispositif selon l'une des revendications précédentes,
**caractérisé en ce que**
un dispositif de chauffage (26) destiné à contrôler la température du substrat donneur (2) est disposé dans l'espace de réception (6) ou sur le boîtier (4), selon lequel au moyen du dispositif de chauffage (26) on peut obtenir de préférence un chauffage du substrat donneur (2) d'une température inférieure à 0°C, en particulier inférieure à -50°C ou à - 100°C ou à -150°C, à la température ambiante.

8. Dispositif selon l'une des revendications précédentes,
**caractérisé en ce que**
un dispositif de réception (28) élastique ou amorti destiné à la réception élastique ou amortie de la partie de corps solide séparée est disposé dans l'espace de réception (6), selon lequel le dispositif de réception (28) élastique ou amorti est disposé de préférence sur le dispositif de maintien et/ou d'homogénéisation (24).
